# EUROPEAN PATENT SPECIFICATION

(11) **EP 0 348 540 B1**
(45) Date of publication and mention of the grant of the patent: **20.01.1993**
(21) Application number: 88110302.2
(22) Date of filing: 28.06.1988
(51) Int. Cl.: H01S 3/19, H01L 33/00

(54) **Process for the selective growth of GaAs**
Verfahren für das selektive Aufwachsen von GaAs
Procédé pour la croissance sélective de GaAs

(43) Date of publication of application: 03.01.1990
(73) Proprietor: International Business Machines Corporation, Armonk, N.Y. 10504 (US)
(72) Inventor: Meier, Heinz Peter, CH-8800 Thalwil (CH); Gieson, Edward A. van, CH-8802 Kilchberg (CH); Walter, Willi, CH-8134 Adliswil (CH)
(74) Representative: Schröder, Otto H., Dr. Ing.

(56) References cited:
- EP-A- 0 190 737
- WO-A-87/00694
- APPLIED PHYSICS LETTERS, vol. 47, no. 7, 1st October 1985, pages 712-715, The American Institute of Physics, Woodbury, New York, US; S. SMITH et al.: "High quality molecular beam epitaxial growth on patterned GaAs substrates"
- APPLIED PHYSICS LETTERS, vol 51, no. 19, 9th November 1987, pages 1512-1514, The American Institute of Physics, Woodbury, New York, US; A. OKAMOTO et al.: "Selective epitaxial growth of gallium arsenide by molecular beam epitaxy"
- FUJITSU SCIENTIFIC & TECHNICAL JOURNAL, vol. 21, no. 4, September 1985, pages 421-426, Kawasaki, JP; T. FUJII et al.: "Very low threshold GaAs-AlGaAs GRIN-SCH lasers grown by MBE for OEIC applications"

## Description

### Technical Field

The invention concerns a process for the selective growth of GaAs on a patterned substrate for use in semiconductor laser diode fabrication. The process is particularly suited for the fabrication of very low threshold current laser devices. The invention also concerns a semiconductor GaAs quantum well (QW) diode laser fabricated by using the selective growth process.

### Background of the Invention

Semiconductor diode lasers have found applications in a wide variety of information handling systems because of their compact size and because their technology is compatible with that of the associated electronic circuitry. These lasers are being used in areas such as data communication, optical storage and laser-beam printing and have been optimized for the particular applications with regard to their wavelength, optical power, their high speed modulation capabilities, beam quality, etc. For all applications, however, high performance devices require low threshold current values, i.e., the minimum current that needs to flow through the p-n junction of the laser diode to cause the coherent emission of light, should be as low as possible. This, in turn, results in a reduction of heat development and the associated cooling problems, an important factor particularly in high packaging density applications. Quantum well structures, in general, are well suited since they require lower currents than conventional heterostructures. An additional measure, resulting in a current reduction, is to provide structures with effective current confinement thereby avoiding unnecessary by-pass or stray currents.

Recently, very high performance low threshold current stripe lasers have been proposed where the active region of the laser is embedded within higher bandgap material in order to provide additional lateral carrier and optical confinement.

One such laser structure has been disclosed by P.L.Derry et al in an article "Ultralow-threshold graded-index separate-confinement single quantum well buried heterostructure (Al,Ga)As lasers with high reflectivity coatings" (Appl.Phys.Lett. 50(25), 22.June 1987, pp 1773-1775).

Described in this article is a buried, graded-index separate-confinement heterostructure (GRINSCH) single quantum well (SQW) laser having a threshold current of below 1 mA. In this laser structure, high bandgap AlGaAs surrounds the active GaAs region in order to prevent carriers from diffusing out of the active region and to also provide for current confinement. The required fabrication process is rather complex involving (1) growing of the laser layers on a flat-surface substrate using molecular beam epitaxy (MBE) techniques, (2) etching grooves to form a ridge-patterned surface structure, and (3) performing a difficult and critical AlGaAs regrowth step using LPE techniques.

A different way of fabricating laser structures with effectively embedded active quantum wells (QW) has been described by J.P.Harbison et al in an article "Patterned quantum well semiconductor injection laser grown by molecular beam epitaxy" (Appl.Phys.Lett 52 (8), 22. February 1988, pp 607 - 609).

Disclosed is an otherwise conventional GaAs/AlGaAs quantum well laser heterostructure that is MBE-grown on an (100)-oriented grooved substrate. Use is made of the fact that lateral variations in the thickness of the quantum wells occur when they are grown on a grooved surface. Due to the thickness variations, lateral patterning of the energy bandgap and the index of refraction is obtained.

Because of the groove geometries, the growth rate normal to the (111) or (411) planes of the groove sidewalls is remarkably lower than the growth rate on the (100)-plane. Injected carriers are confined to a narrow stripe, about 1 µm wide, at the bottom of the groove because of the larger effective bandgap of the thinner QW layers on both sides of the stripe. Current confinement, desired to prevent the applied injection current from by-passing the p-n junction of the active region, is achieved by proton implantation whereby the walls of the groove are rendered non-conducting, leaving a conductive stripe, about 2 µm wide, at the bottom of the groove. This additional process step is not self-aligned and thus limits further reduction in device size.

### Summary of the Invention

It is a main object of the present invention to provide a novel process for the selective growth of GaAs on selected surface planes of a patterned GaAs substrate surface.

Another object is to provide a reliable, reproducible process for the fabrication of high-performance semiconductor ridge laser structures with embedded active quantum wells, exploiting the difference in surface diffusion and desorption of the different facet planes of the ridge structure.

Still another object is to provide a high-performance quantum well ridge laser structure having its active region completely embedded in the higher bandgap cladding layers of the device.

The invention as claimed is intended to meet these objectives and to remedy the drawbacks hitherto encountered. For a ridge GaAs QW laser, the invention provides a way to embed the active QW in higher bandgap material by selective growth of the QW on the horizontal facet of the ridge structure, leaving the sidewall facets of the ridge exposed to the deposition of the higher bandgap cladding layers. These provide for lateral carrier and current confinement.

The advantages offered by the invention are mainly that the described MBE growth process provides a substantially simplified process for embedding the active quantum well. This reliable, self-aligned process allows the fabrication of high-performance laser structures of very small size, possibly down to sub-micron dimensions. Lasers fabricated in accordance with the inventive method operate at very low threshold current levels resulting in low heat dissipation and thus permitting high packaging densities.

### Description of the Drawings

One way of carrying out the invention is described in detail below with reference to drawings which illustrate a specific embodiment and in which
- Fig.1: is a schematic cross-sectional representation of a QW laser used for the illustration of the structural and operational principles of the laser structure produced in accordance with the inventive process;
- Fig.2A - 2F: are illustrations of the steps of the inventive process used to fabricate a ridge QW laser structure; and
- Fig.3: is a cross-sectional representation of a ridge QW laser structure produced in accordance with the inventive process.

### Detailed Description

Before describing the invention in more detail, reference is made to an article by H.P.Meier et al "Channeled Substrate (100) GaAs MBE Growth and Lateral p-n Junction Formation for Lasers" (Proc.Intern.Symp. on GaAs and Related Compounds, Heraklion, Crete, Greece, September 28 - October 1,1987, pp 609 - 612).

This paper presents some basic technology background on which the invention is based. It reports on investigations made to better understand the MBE growth mechanism of AlGaAs over (100) ridge structures with (211) or higher order (m11A) sidewall facets. At growth temperatures in the order of 720°C, Ga diffuses from the A-facets to the (100)-facet, the diffusion and the desorption for Ga being much higher than for Al. As a consequence, the GaAs growth rate, and thus the incorporation rate of Ga, are lower on the A-planes than on the (100) facets. It has also been found that the growth rates and the Al-concentration at the (100)-facets depend on the ridge width : for narrow ridges, the growth rate is high and the Al-concentration low.

In essence, at high temperatures considerable redistribution of Ga from the sidewall facets to the horizontal ridge plane occurs, leading to an increase in QW thickness on the favored growth (100)-planes.

Further investigations and developments, resulting in modifications and optimization of the earlier findings, have now led to the process of the present invention which can be applied in laser device fabrication. The key novel step in the process, accounting for the progress the process yields, is a growth interrupt phase. It is this step that allows the degree of Ga growth selectivity that is required for the fabrication of very high performance lasers.

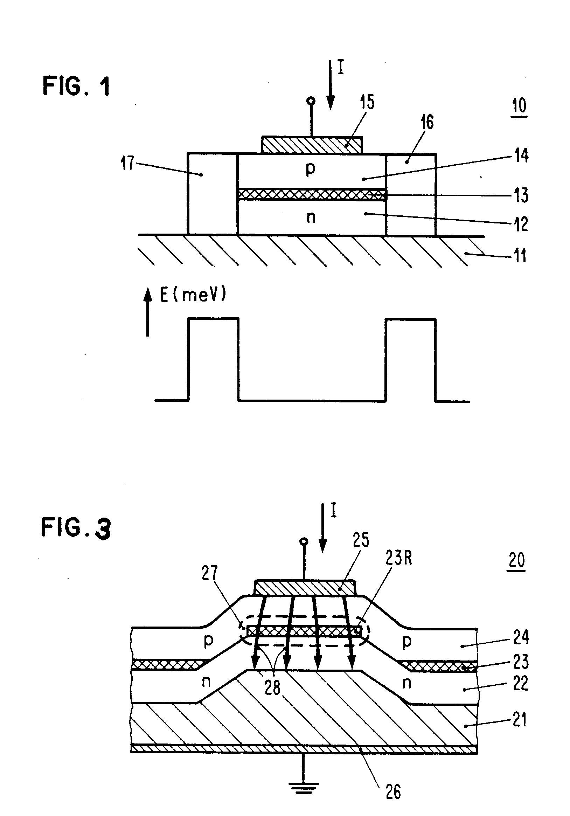

Referring now to the drawings and first to Fig.1 thereof, there is shown a schematic cross-sectional representation of a GaAs laser having an embedded active region. This structure will be used to explain the structural and operational principles of the type of laser device that can be fabricated with the inventive process.

Laser structure 10, deposited on the planar surface of a substrate 11, comprises a bottom cladding layer 12, an active layer 13 and an upper cladding layer 14. The active layer 13 consists of GaAs whereas the cladding layers are made of AlGaAs, layer 12 being n-doped, layer 14 p-doped. Upon feeding a current I of a magnitude equal to or higher than that of the threshold current of the device, to electrode 15 (the counterelectrode, connected to the substrate, is not shown), a laser beam is emitted from the active zone in a direction perpendicular to the plane of the drawing.
AlGaAs deposits 16 and 17, having a bandgap that is higher than that of the GaAs, embed the active layer 13 providing an energy (E) barrier as illustrated in the lower part of the figure. Due to this barrier, carrier confinement is provided, the difference in the refractive index of GaAs and AlGaAs resulting in the required optical confinement.

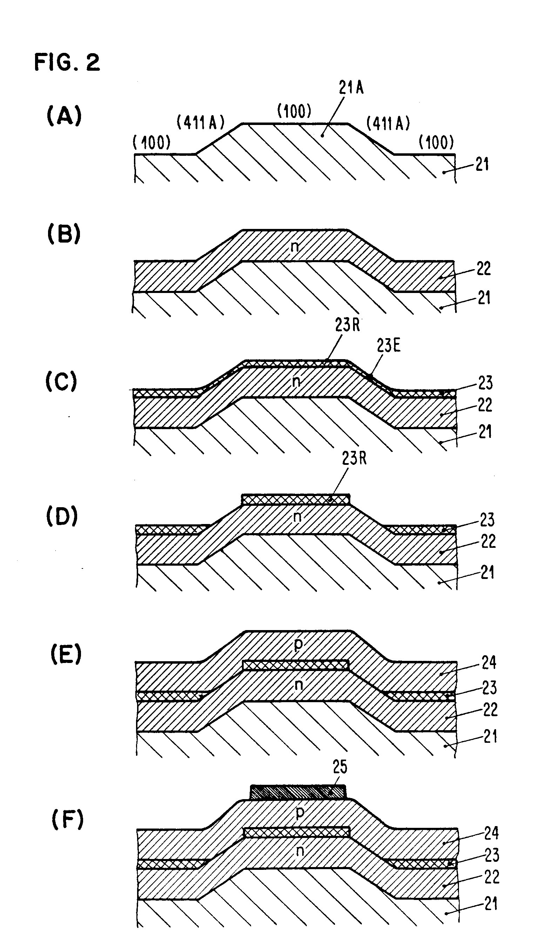

In Fig. 2A - 2F the steps of the inventive process, applied to fabricate a ridge laser structure having an embedded active quantum well, are illustrated in detail. The successive steps are listed in table I indicating the correspondence between the steps and the drawings.

**TABLE I**

| Step No. | Despription of Process Step | Figure |
|---|---|---|
| Starting point | A ((100)-oriented) semiconductor substrate (21) having a ridge-patterned surface, the sidewall facets having a crystall orientation (411A) different from that of the horizontal top plane. | 2A |
| 1 | MBE-growth of an n-type lower AlGaAs cladding layer (22). | 2B |
| 2 | High temperature MBE-growth of a GaAs QW layer (23). Due to Ga diffusion and desorption at the sidewalls, preferred GaAs growth on the horizontal plane (23R). | 2C |
| 3 | Short growth interrupt causing complete GaAs removal from the sidewall facets. | 2D |
| 4 | MBE-growth of an p-type upper AlGaAs cladding layer (24) embedding the GaAs QW (23R) in higher bandgap material. | 2E |
| 5 | Deposition of the top ohmic contact current electrode (25) | 2F |
| Not shown : the deposition of the second current electrode connected to the substrate. | | |

Referring now to Fig.2A, the fabrication process is initiated starting from a n+ GaAs substrate 21 having at least one ridge 21A on which the laser diode is to be grown. The horizontal facets are (100)-oriented, the sidewalls or edges (411A)- or, more generally, (m11A)-oriented.

The surface pattern shown in Fig.2A can, for example, be obtained using an (100)-oriented substrate. The desired facets can be etched in an isotropic wet-etch process, using, e.g., a 2 : 1 : 20 mixture of buffered HF : H₂O₂ : H₂O where the H₂O₂ concentration determines the angle of the facets.

A stack of semiconductor layers 22 to 24 is then grown on the structured substrate surface using a conventional MBE process as illustrated in Fig.2B to 2E.

After careful cleaning and loading into the MBE system, the lower AlGaAs cladding layer 22, n-doped, is grown in step 1 at a temperature of about 720 degrees (Fig.2B). With a low Arsenic flux, in order not to jeopardize the diffusion and desorption effect, the growth process is controlled to yield a layer of an Al-concentration of x=0.4, the deposited Al_{0.4}Ga_{0.6}As layer having a thickness of about 1.5 µm.

In step 2, illustrated in Fig. 2C, the active layer 23 of undoped GaAs is grown while keeping the temperature at about 720 degrees. Due to the high surface diffusion and desorption of Ga at the (411A)-facet, deposits of different thickness are obtained, the thickness of the layer on the (100)-plane being between 5 and 10 nm. The Ga incorporation rate differs. In the example, growth is continued until the thickness on the (100)-plane on the top of the ridge is about 8 nm (region 23R), the GaAs layers on the sidewall facets being only about 5 nm thick (region 23E).

It is noted that this difference in thickness of the GaAs layer on the (100)- and the (411A)-facets is primarily due to the diffusion and desorption effect. With the low-incline slope of the sidewalls, the differentiation in thickness due to any "geometry effect" of the MBE process is virtually neglectable. This is in contrast to the process described in the above referenced article by J.P.Harbison et al where the "geometry effect", in connection with the steep slopes accounts for the thickness variation.

Thereafter, in step 3, growth is interrupted in that the supply of Ga and As is cut off for about 1 minute while still maintaining the high temperature.

It has been found that, during this growth interrupt, the thin (5 nm) GaAs layer 23E desorbes completely from the sidewall facets exposing the surface of the underlying lower cladding layer 22. The GaAs active layer section 23R at the (100)-facet is now isolated. It forms the active QW of the laser structure. The structure obtained after completion of this most important process step is shown in Fig.2D.

In the subsequent step 4, the upper cladding layer 24, having the same composition Al_{0.4}Ga_{0.6}As as the lower cladding layer 22 but being n-doped, is deposited onto the structure as illustrated in Fig.2E. The process conditions are the same as those of step 1. The thickness of layer 24 is also about 1.5 µm.

Since the upper cladding layer 24 is, in the (411A)-facet region, directly deposited onto the lower cladding layer 22, the active GaAs QW 23R is completely embedded in the higher bandgap AlGaAs cladding layer material. In the completed device, this provides for both, lateral carrier confinement and lateral current confinement.

It should be noted that no additional process step is required for obtaining current confinement. This is in contrast to the processes described in the two prior art references cited in the introduction. There, either an AlGaAs regrowth (in the P.L.Derry et al process) or a proton implantation (in the J.P.Harbison et al process) is required.

Next, in step 5, reference is now made to Fig.2F, ohmic contacts for the application of the injection current I to the p-n laser diode are deposited using conventional methods and materails. In the described embodiment, the upper p-contact consists of Ti/Pt/Au whereas the n-contact electrode (not shown in the figure) that is connected to the substrate, is made of Au/Ge/Ni/Au.

With some minor modifications, the above described process can also be used to fabricate different types of semiconductor laser structures. One example is a graded refractive index - separate confinement heterostructure (GRINSCH) laser which permits independent optimization of the optical and the carrier confinement. For a GRINSCH structure, step 1 (Fig.2B) and step 4 (Fig.2E) are modified in order to provide for the graded refractive index zone. The bulk of the lower and upper cladding layers, 22 and 24, respectively, is grown as described above. But in the zones adjacent the active layer 23R, these zones of about 0.2 µm thickness being referred to as waveguide layers, the Al-contents are graded from x = 0.4 at the transition to the the respective cladding layer, to x = 0.18 at the boundary with the active layer 23R. The grading is linear but may also be parabolic or of another characteristic.

Other deviations from the above described fabrication process or from the resulting laser structure may be made without departing from the teaching of the invention. For example, the active region may consist of a multi-QW structure; the GaAs forming the active QW may be doped; the p-n "polarity" may be reversed with the consequence that the junction current needs to flow in the opposite direction; etc. Also, the process parameters, the materials used, the indicated thicknesses and other device parameters required or chosen for the described embodiments, are not to be interpreted in a limiting sense.

Fig.3 is a schematic representation of a completed GaAs laser structure that can be fabricated using the above described process. Where appropriate, the same reference numbers have been used for corresponding structural elements as in Fig.2.

The layered semiconductor diode laser structure 20 is grown on a n+ GaAs substrate 21. It comprises n-type lower and p-type upper AlGaAs cladding layers 22 and 24. Active GaAs region 23R, forming a quantum well, is completely embedded inbetween these layers. The actual laser structure may be of the GRINSCH-type in which case the graded waveguide layers adjacent the active quantum well allow independent optimization of optical and electric properties of the device.

When a current I of a magnitude equal to or above that of the threshold current of the laser is fed from the ohmic contact electrode 25 down through layers 24, 23 and 22 to the substrate 21 and to electrode 26, recombination of carriers in the active quantum well region 23R leads to the emission of light. The light-emitting zone, indicated by the dotted curve 27, includes the quantum well 23R as well as the immediately neighbouring zones of the cladding layers 22 and 24.

With the active quantum well 23R completely embedded within the higher bandgap AlGaAs cladding layers, the structure provides for very effective carrier confinement since the energy barriers formed in the sidewall regions, as schematically shown in Fig.1, prevent injected carriers from diffusing out of the active region.

With the GaAs layer being non-existent in the sidewall regions, the structure also provides for very effective current confinement since the turn-on voltage of the p-n junction in the quantum well region is substantially lower than that of the sidewall p-n junctions whereby the flow of the applied current I through the latter is prevented, it is confined to the path through the quantum well as indicated by the arrows 28.

## Claims

1. Process for the selective growth of GaAs on a patterned GaAs substrate for use in semiconductor laser diode fabrication,
the process comprising the steps of
* patterning the surface of the GaAs substrate (21) to provide a ridge structure (21A) on which a semiconductor laser diode is to be grown, the horizontal facets of the ridge being (100)-oriented and the sidewall facets being (m11A)-oriented, the side wall facets of the ridge structure having, due to the different crystal orientation, a lower Ga incorporation rate than that of the horizontal facets,
and
* depositing the layers (22, 23, 24) forming the semiconductor laser diode on the patterned GaAs substrate (21) in a molecular beam epitaxy (MBE) system at a temperature above 700^{o}C as follows :
- growth of an AlGaAs lower cladding layer (22) of a first conductivity type on all facets of the ridge structure,
- growth of an active GaAs quantum well (23) until a layer thickness between 5 and 10 nm is obtained on the top horizontal plane (23R), the thickness on the sidewall facets, having a lower Ga incorporation rate (23E), being lower,
- growth interrupt by stopping the Ga supply until complete desorption of the thin GaAs layer (23E) from the sidewall facets,
- growth of an AlGaAs upper cladding layer (24) of a second conductivity type on all facets of the structure,
whereby the active quantum well (23R), serving as cavity of the completed semiconductor laser diode, is laterally embedded within higher bandgap material (22, 24) that provides for lateral carrier and current confinement.

2. Process as claimed in claim 1, wherein the sidewall facets are (411A)-oriented.

3. Process as claimed in claim 1, wherein the AlGaAs composition of the lower and upper cladding layers (22, 24) is Al_{0.4}Ga_{0.6}As.

4. Process as claimed in claim 3, wherein the lower and upper cladding layers (22, 24) include, adjacent the embedded quantum well (23R), a waveguide layer with a graded Al-content.

5. Process as claimed in claim 4, wherein the AlGaAs composition within the waveguide layers varies from Al_{0.18}Ga_{0.82}As at the interface with the quantum well to Al_{0.4}Ga_{0.6}As at the transition to the bulk of the cladding layers.

6. Process as claimed in claim 1, wherein the temperature at which the layers (22, 23, 24) forming the laser diode are grown in the MBE system is about 720^{o}C.

7. Process as claimed in claim 1, wherein the thickness of the lower and upper cladding layers (22, 24) is about 1.5 µm.

8. Process as claimed in claim 1, wherein the growth interrupt takes place for about 1 minute.

9. Semiconductor quantum well (QW) diode laser (20) having the QW (23R) embedded in higher bandgap material (22, 24) providing for lateral electric confinement,
- the laser comprising a layered structure (22, 23, 24) including the active GaAs QW layer (23R) sandwiched inbetween lower and upper AlGaAs cladding layers (22, 24), the material of the latter having a higher bandgap than that of the the active QW layer (23R),
- the layers of said layered structure are deposited on a ridge (21A) of a patterned GaAs substrate surface, the (m11A)-oriented sidewall facets of said ridge having, due to the different crystal orientation, a lower Ga incorporation rate than that of the horizontal (100)-oriented facets, characterized in that
- the active QW layer (23R) is selectively deposited on the (100)-oriented horizontal section of the lower cladding layer (22) whereas the (m11A)-oriented side wall section of the lower cladding layer is free of any deposited active layer material and thus in direct contact with the upper cladding layer (24),
whereby the active QW layer (23R) is completely embedded within the higher bandgap cladding layer material (22, 24).

10. A Diode laser as claimed in claim 9, wherein the lower and upper cladding layers (22, 24) include, adjacent the embedded quantum well (23R), a waveguide layer with a graded Al-content.

## Patentansprüche

1. Verfahren für das selektive Aufwachsen von GaAs auf einem strukturierten GaAs-Substrat zur Verwendung bei der Herstellung einer Halbleiter-Laserdiode,
wobei das Verfahren die folgenden Schritte umfaßt:
Strukturierender Oberfläche des GaAs-Substrats (21), um eine Ridgestruktur (21A) herzustellen, auf der eine Halbleiter-Laserdiode durch Aufwachsen gebildet werden soll, wobei die horizontalen Flächen des Ridges (100)-orientiert sind und die Seitenwandflächen (m11A)-orientiert sind und die Seitenwandflächen der Ridgestruktur infolge der unterschiedlichen Kristallorientierung eine kleinere Einbettungsrate für Ga aufweisen, als jene der horizontalen Flächen und
Aufbringen der Schichten (22, 23, 24), welche die Halbleiter-Laserdiode auf dem strukturierten GaAs-Substrat (21) bilden, in einem Molekularstrahlepitaxie (MBE)-System bei einer Temperatur über 700°C wie folgt:
Aufwachsen einer unteren AlGaAs-Hüllschicht (22) eines ersten Leitfähigkeitstyps auf allen Flächen der Ridgestruktur
Aufwachsen eines aktiven GaAs-Quantumwells (23) bis eine Schichtdicke zwischen 5 und 10 nm auf der oberen horizontalen Ebene (23R) erzielt wird, wobei die Dicke an den Seitenwandflächen (23E), die eine kleinere Einbettungsrate für Ga besitzen, geringer ist,
Unterbrechen des Aufwachsens durch Stoppen der Ga-Versorgung bis zur vollständigen Desorption der dünnen GaAs-Schicht (23E) von den Seitenwandflächen,
Aufwachsen einer oberen AlGaAs-Hüllschicht (24) eines zweiten Leitfähigkeitstyps auf allen Flächen der Struktur,
wodurch das aktive Quantumwell (23R), das als eine Kavität der fertigen Halbleiter-Laserdiode dient, seitlich innerhalb eines Materials (22, 24) größeren Bandabstands eingebettet ist, das für eine seitliche Träger- und Strombegrenzung sorgt.

2. Verfahren nach Anspruch 1, bei welchem die Seitenwandflächen (411A) - orientiert sind.

3. Verfahren nach Anspruch 1, bei welchem die AlGaAs-Zusammensetzung der unteren und der oberen Hüllschicht (22, 24) Al_{0.4}Ga_{0.6}As ist.

4. Verfahren nach Anspruch 3, bei welchem die untere und die obere Hüllschicht (22, 24) benachbart zu dem eingebetteten Quantumwell (23R) eine Wellenleiterschicht mit einem abgestuften Al-Gehalt aufweisen.

5. Verfahren nach Anspruch 4, bei welchem sich die AlGaAs-Zusammensetzung innerhalb der Wellenleiterschichten von Al_{0.18}Ga_{0.82}As an der Grenzfläche mit dem Quantumwell zu Al_{0.4}Ga_{0.6}As an dem Übergang zur Masse der Hüllschichten hin ändert.

6. Verfahren nach Anspruch 1, bei welchem die Temperatur, bei welcher die die Laserdiode bildenden Schichten (22, 23, 24) in dem MBE-System durch Aufwachsen gebildet werden, ungefähr 720°C beträgt.

7. Verfahren nach Anspruch 1, bei welchem die Dicke der unteren und der oberen Hüllschicht (22, 24) ungefähr 1,5 µm beträgt.

8. Verfahren nach Anspruch 1, bei welchem die Unterbrechung des Aufwachsens für etwa 1 Minute erfolgt.

9. Halbleiterdiodenlaser (20) mit einem Quantumwell (QW), bei dem das QW (23R) in einem Material (22, 24) größeren Bandabstands eingebettet ist, das für eine seitliche elektrische Begrenzung sorgt, wobei
der Laser eine Schichtstruktur (22, 23, 24) aufweist, welche die aktive GaAs QW-Schicht (23R) einschließt, die sandwichartig zwischen unteren und oberen AlGaAs-Hüllschichten (22, 24) liegt und das Material der letzteren einen größeren Bandabstand besitzt, als das der aktiven QW-Schicht (23R),
die Schichten der Schichtstruktur auf einem Ridge (21A) einer strukturierten GaAs-Substratoberfläche aufgebracht sind und die (m11A)-orientierten Seitenwandflächen des Ridges infolge der unterschiedlichen Kristallorientierung eine kleinere Einbettungsrate für Ga aufweisen, als jene der horizontalen (100)-orientierten Flächen,
dadurch gekennzeichnet, daß
die aktive QW-Schicht (23R) selektiv auf dem (100)-orientierten horizontalen Abschnitt der unteren Hüllschicht (22) aufgebracht ist, wogegen der (m11A)-orientierte Seitenwandabschnitt der unteren Hüllschicht kein aufgebrachtes Aktivschicht-Material aufweist und folglich mit der oberen Hüllschicht (24) unmittelbar in Kontakt steht,
wodurch die aktive QW-Schicht (23R) vollständig innerhalb des Hüllschichtmaterials (22, 24) mit größerem Bandabstand eingebettet ist.

10. Diodenlaser nach Anspruch 9, bei welchem die untere und die obere Hüllschicht (22, 24) benachbart zu dem eingebetteten Quantumwell (23R) eine Wellenleiterschicht mit einem abgestuften Al-Gehalt aufweisen.

## Revendications

1. Procédé pour la croissance sélective de GaAs sur un substrat en GaAs mis en forme, à utiliser pour la fabrication de lasers à semiconducteur, le procédé comprenant les étapes suivantes :
- la mise en forme de la surface du substrat de GaAs (21) de façon à créer une structure à nervure (21A) sur laquelle on devra faire croître un laser à semiconducteur, les facettes horizontales de la nervure étant orientées (100) et les facettes des parois latérales étant orientées (m11A), les facettes des parois latérales de la structure à nervure étant affectées, en raison de l'orientation différente du cristal, d'une vitesse d'incorporation de Ga plus faible que celle des facettes horizontales, et
- le dépôt des couches (22, 23, 24) formant le laser à semiconducteur sur le substrat de GaAs mis en forme (21), dans un système à épitaxie par faisceau moléculaire (MBE) à une température supérieure à 700°C, de la manière suivante :
- la croissance d'une couche de dépôt inférieure de AlGaAs (22) d'un premier type de conductivité sur toutes les facettes de la structure à nervure,
- la croissance d'un puits quantique de GaAs actif (23) jusqu'à ce qu'une épaisseur de couche comprise entre 5 et 10 nm soit obtenue sur le plan horizontal supérieur (23R), l'épaisseur sur les facettes des parois latérales qui sont affectées d'une vitesse d'incorporation de Ga plus faible (23E), étant moindre,
- l'interruption de la croissance par l'arrêt de l'alimentation en Ga jusqu'à la désorption complète de la couche mince de GaAs (23E) des facettes des parois latérales,
- la croissance d'une couche de dépôt supérieure de AlGaAs (24) d'un second type de conductivité sur toutes les facettes de la structure, ce qui permet au puits quantique actif (23R) faisant fonction de cavité dans le laser à semiconducteur terminé, d'être latéralement noyé dans le matériau à bande interdite plus élevé (22, 24) qui assure le confinement latéral des porteurs et du courant.

2. Procédé selon la revendication 1, dans lequel les facettes sont orientées (411A).

3. Procédé selon la revendication 1, dans lequel la composition du AlGaAs des couches de dépôt inférieure et supérieure (22, 24) est Al_{0.4}Ga_{0.6}As.

4. Procédé selon la revendication 3, dans lequel les couches de dépôt inférieure et supérieure (22, 24) comprennent dans une position adjacente au puits quantique noyé (23R) une couche guide d'ondes à teneur en Al graduelle.

5. Procédé selon la revendication 4, dans lequel la composition du AlGaAs des couches de guidage d'ondes varie de Al_{0.18}Ga_{0.82}As à l'interface avec le puits quantique, à Al_{0.4}Ga_{0.6}As à la transition dans la masse ces couches de dépôt.

6. Procédé selon la revendication 1, dans lequel la température à laquelle on fait croître les couches (22, 23, 24) formant la diode laser dans le système MBE, est de l'ordre de 720°C.

7. Procédé selon la revendication 1, dans lequel l'épaisseur des couches de dépôt inférieure et supérieure (22, 24) est de l'ordre de 1,5 µm.

8. Procédé selon la revendication 1, dans lequel l'interruption de la croissance dure approximativement une minute.

9. Diode laser à semiconducteur (20) à puits quantique (QW) (23R) noyé dans le matériau à bande interdite plus élevé (22, 24) assurant le confinement électrique latéral,
- le laser comprenant une structure en couches (22, 23, 24) comprenant la couche QW de GaAs actif (23R) disposée intérieurement en sandwich entre les couches de dépôt de AlGaAs inférieure et supérieure (22, 24), le matériau composant ces dernières présentant une bande interdite plus élevé que celui de la couche de QW active (23R),
- les couches de ladite structure en couches sont déposées sur une nervure (21A) d'une surface de substrat de GaAs mis en forme, les facettes des parois latérales orientées (m11A) de ladite nervure présentant, en raison de l'orientation différente du cristal, une vitesse d'incorporation de Ga inférieure à celle des facettes horizontales orientées (100),
caractérisé en ce que :
la couche de QW active (23R) est sélectivement déposée sur la partie horizontale orientée (100) de la couche de dépôt inférieure (22) tandis que la partie à parois latérales orientées (m11A) de la couche de dépôt inférieure est exempte de tout matériau formant la couche active déposée et est ainsi placée en contact direct avec la couche de dépôt supérieure (24),
ce qui fait que la couche de QW active (23R) est complètement noyée dans le matériau formant les couches de dépôt à intervalle de bande plus élevé (22, 24).

10. Diode laser selon la revendication 9, dans laquelle les couches de dépôt inférieure et supérieure (22, 24) comprennent dans une position adjacente au puits quantique noyé (23R), une couche guide d'ondes à teneur en Al graduelle.
